# EUROPÄISCHE PATENTSCHRIFT

(11) **EP 2 414 847 B1**
(45) Veröffentlichungstag und Bekanntmachung des Hinweises auf die Patenterteilung: **26.06.2013**
(21) Anmeldenummer: 10716503.7
(22) Anmeldetag: 01.04.2010
(51) Int. Cl.: G01R 1/073, G01R 1/067

(54) **KONTAKTIERUNGSEINHEIT FÜR EINE TESTVORRICHTUNG ZUM TESTEN VON LEITERPLATTEN**
CONTACT-CONNECTION UNIT FOR A TEST APPARATUS FOR TESTING PRINTED CIRCUIT BOARDS
UNITÉ DE CONNEXION POUR DISPOSITIF D'ESSAI DESTINÉ À TESTER DES PLAQUETTES À CIRCUIT IMPRIMÉ

(30) Priorität: 03.04.2009 DE 102009016181
(43) Veröffentlichungstag der Anmeldung: 08.02.2012
(73) Patentinhaber: DTG International GmbH, 8005 Zürich (CH)
(72) Erfinder: DEHMEL, Rüdiger, 31515 Wunstorf (DE); GÜLZOW, Andreas, 31832 Springe (DE)
(74) Vertreter: Ganahl, Bernhard
(86) Internationale Anmeldenummer: PCT/EP2010/054410
(87) Internationale Veröffentlichungsnummer: WO 2010/112584

(56) Entgegenhaltungen:
- EP-A1- 0 315 707
- WO-A2-2009/047160
- DE-A1- 3 630 548
- DE-A1- 3 906 691
- DE-C1- 19 644 725
- DE-U1- 8 534 841
- US-A- 5 307 560
- US-A- 5 493 230
- US-A1- 2003 016 037

## Beschreibung

Die Erfindung betrifft eine Kontaktierungseinheit umfassend eine Vollrasterkassette und einen Adapter für einen Paralleltester zum Testen einer unbestückten Leiterplatte.

Vorrichtungen zum Testen von Leiterplatten werden in zwei Gruppen unterteilt, den Fingertestern, die mit mehreren Kontaktfingern Prüfpunkte einer zu untersuchenden Leiterplatte seriell abtasten, und den Paralleltestern, die alle Prüfpunkte bzw. Leiterplattentestpunkte einer zu untersuchenden Leiterplatte gleichzeitig mittels eines Adapters kontaktieren. Derartige Adapter werden auch als Rasteranpassungsadapter bezeichnet, da sie ein vorbestimmtes, regelmäßiges Grundraster der Prüfvorrichtung auf die üblicherweise unregelmäßige Anordnung der Leiterplattentestpunkte einer zu testenden Leiterplatte umsetzen. Ein solcher Adapter weist in der Regel mehrere voneinander beabstandete Führungsplatten auf, in welchen Führungslöcher zur Aufnahme von Prüfnadeln eingebracht sind. Die Prüfnadeln können im Adapter schräg angeordnet sein, so dass sie Kontaktpunkte des regelmäßigen Grundrasters mit den Leiterplattentestpunkten elektrisch verbinden können, die in der Regel von der regelmäßigen Anordnung des Grundrasters abweichen.

In der Regel wird der Adapter nicht unmittelbar auf dem Grundraster angeordnet, sondern es wird zwischen dem Grundraster und dem Adapter eine sogenannte Vollrasterkassette vorgesehen. Eine Vollrasterkassette ist ähnlich wie der Adapter aus mehreren Führungsplatten ausgebildet, in welcher Kontaktstifte in dem gleichen Raster wie das Grundraster vorgesehen sind. Diese Kontaktstifte sind federnd ausgebildet. Der Grund, weshalb eine derartige Vollrasterkassette verwendet wird, ist, dass derartige federnden Kontaktstifte in den das Raster des Grundrasters auf die Leiterplattentestpunkte der zu testenden Leiterplatte abbildenden Adapter eingesetzt werden können, da diese zu dick sind, um sie im Adapter schräg anordnen zu können. Andererseits ist es notwendig, dass Höhenunterschiede aufgrund von Unebenheiten in der zu prüfenden Leiterplatte bzw. aufgrund der Schrägstellung der Nadeln im Adapter durch die federnden Kontaktstifte der Vollrasterkassette ausgeglichen werden können.

Eine solche Vollrasterkassette kann integraler Bestandteil der Prüfvorrichtung sein. Die Vollrasterkassette kann jedoch auch ein separat ausgebildetes Bauteil sein, das austauschbar auf dem Grundraster der Prüfvorrichtung anordbar ist.

Für einen zu prüfenden Leiterplattentyp muss jeweils ein spezieller Adapter hergestellt werden. Die Vollrasterkassette ist hingegen unabhängig vom Typ der zu prüfenden Leiterplatte.

Im Adapter können sogenannte Glattnadeln verwendet werden. Das sind dünne, geradlinige Drahtabschnitte mit einer Stärke von 0,1 mm bis 0,2 mm. Da heutzutage fast alle Prüfvorrichtungen zum zweiseitigen Testen einer Leiterplatte ausgebildet sind, sind in einer Prüfvorrichtung sowohl unterhalb der zu testenden Leiterplatte als auch oberhalb der zu testenden Leiterplatte jeweils ein Adapter vorzusehen. Damit die Nadeln nicht aus dem Adapter herausfallen, müssen sie darin fixiert werden. Bei Verwendung derartiger Glattnadeln erfolgt die Fixierung entweder mittels einer gelochten Latex-Folie oder einem Nylongewebe. Die Latex-Folie muss an den Stellen, wo sie von den Nadeln durchstochen wird, vorgebohrt sein. Das Bohren einer derartigen Folie ist sehr aufwendig und schwierig. Die Verwendung eines Gewebes ist wesentlich einfacher, da die Nadeln das Gewebe zwischen den einzelnen Gewebefäden durchstechen können. Jedoch wird hierdurch ein Versatz auf die Nadeln ausgeübt, der bei einer zunehmenden Erhöhung der Dichte der Leiterplattentestpunkte und damit auch der Dichte der Nadeln zu erheblichen Problemen führt.

Aus der EP 149 776 B1 sind Prüfnadeln für einen Adapter bekannt, die an einem Ende einen Kugelkopf aufweisen, der verhindert, dass die Prüfnadeln in den Adapter rutschen. Der darin gezeigte Adapter ist jedoch nur zur Verwendung von Prüfvorrichtungen zum einseitigen Testen von Leiterplatten geeignet, da die Prüfnadeln mit ihrem Kugelkopf immer auf der Oberseite des Adapters angeordnet sein müssen und der Adapter nicht umgedreht werden kann. Dieser Typ von Prüfnadeln wurde dahingehend weiterentwickelt, dass die Nadeln mit einem kugelförmigen Kunststoffkopf versehen werden, der ein kleines Stück vom oberen Ende der Nadeln beabstandet ist. Hierdurch ist es möglich, auf dem Adapter eine weitere Lochplatte anzuordnen, so dass die Kunststoffköpfe der Nadeln zwischen dieser Lochplatte und einer weiteren Führungsplatte fixiert sind. Die derart fixierten Nadeln können nicht mehr aus dem Adapter herausfallen. Jedoch erfordern diese Kunststoffköpfe und die zusätzliche Fixierplatte einen Mindestabstand zwischen den benachbarten Nadeln, so dass diese Art der Fixierung keine weitere Erhöhung der Dichte der Anordnung der Nadeln erlaubt.

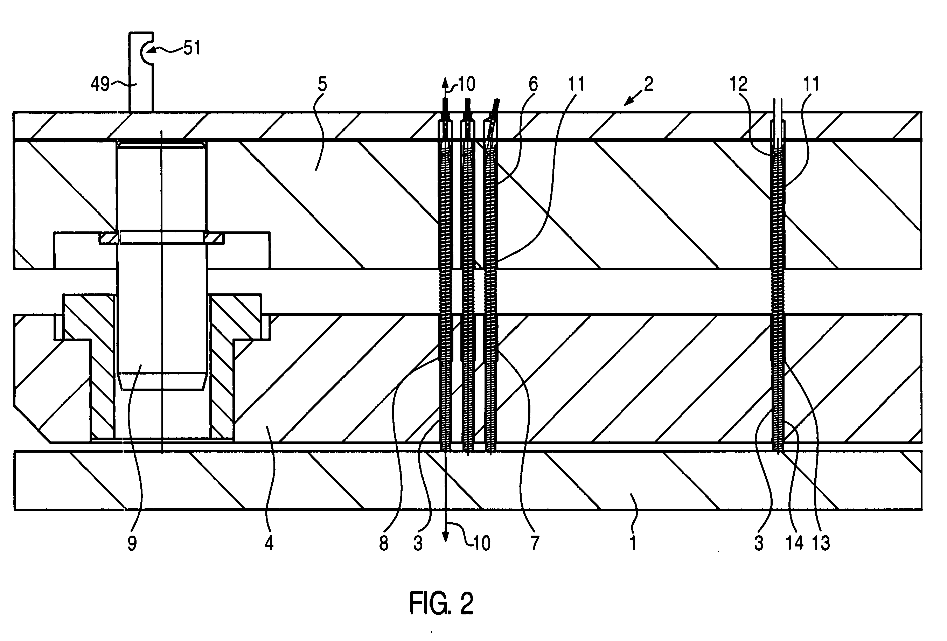

In der deutschen Patentanmeldung DE 10 2006 059 429 A1 ist ein Paralleltester zum Testen von unbestückten Leiterplatten beschrieben, dessen Grundraster aus zwei ineinander verschränkten quadratischen Rastern ausgebildet ist. Ein jedes quadratische Raster hat einen Rasterabstand von 50 mil 1,27 mm. Die beiden Raster sind jeweils in X- und Y-Richtung um einen halben Rasterabstand (= 25 mil 0,635 mm) zueinander versetzt (Figur 2b). Ein solches Raster kann auch als ein um 45° schräg gestelltes quadratisches Raster dargestellt werden, wobei der Rasterabstand dieses schräg gestellten quadratischen Rasters etwa 0,89 mm beträgt. Die Dichte der Kontaktstellen am gesamten Grundraster beträgt 124 Kontaktpunkte pro Quadratzentimeter. Da die Leiterplattentestpunkte an den zu prüfenden Leiterplatten unregelmäßig angeordnet sind, gibt es hier Bereiche, in welchen die Dichte nochmals deutlich erhöht ist. So kann z. B. die Dichte in einem Flächenbereich von z. B. 1 cm x 1 cm bis über 600 Leiterplattentestpunkte betragen.

Mit den bekannten Adaptern können lokal sehr enge Abstände zwischen benachbarten Prüfnadeln erzielt werden. So gehen aus der EP 1 206 704 B1 Prüfnadeln für einen Adapter hervor, die an ihrem freien Ende eine sich konisch verjüngende Kontaktspitze aufweisen. Mit diesen Nadeln können Abstände zwischen benachbarten Kontaktspitzen von 0,25 mm oder kleiner erzielt werden. Jedoch ist es aufgrund der oben erläuterten Fixierungsmethoden (Latex-Folie, Gewebe, Kunststoffköpfe) nicht möglich, in einem vorbestimmten Flächenbereich von zum Beispiel 1 cm x 1 cm eine Vielzahl von Prüfnadeln mit einem derart engen Abstand anzuordnen. Es besteht daher ein erheblicher Bedarf nach einer Vorrichtung zum Kontaktieren einer Leiterplatte, die es erlaubt, Prüfnadeln mit ihren zu der zur testenden Leiterplatte weisenden Enden mit einer Dichte von 600 Prüfnadeln pro cm² anzuordnen.

Die DE 196 44 725 C1 zeigt den grundsätzlichen Aufbau einer Vollrasterkassette beschrieben. In dieser Vollrasterkassette sind Vollrasterstifte gelagert, die jeweils aus einem oberen und einem unteren Stiftabschnitt bestehen, die jeweils über eine Schraubenfeder mit einander elastisch und elektrisch leitend verbunden sind. Die Feder weist einen größeren Durchmesser als die Stiftabschnitte auf. Die jeweiligen Bohrungen zur Aufnahme der Stiftabschnitte und der Feder sind stufig ausgeführt, so dass die Vollrasterstifte verliersicher in der Vollrasterkassette gehalten werden.

In der DE 199 00 833 B4 ist eine Testhalterung zum Halten von bedruckten Leiterplatten in einer Prüfvorrichtung beschrieben. Die Testhalterung weist eine Trägerplatte auf, auf der eine Sondenplatte angeordnet ist. Sowohl in der Trägerplatte 12 als auch in der Sondenplatte sind Bohrungen zum Aufnehmen von Federdrucksonden vorgesehen. Zwischen der Trägerplatte und der Sondenplatte ist eine Sondenhaltefolie angeordnet, durch die sich die Federdrucksonden erstrecken. Die Folie kann aus Gummi mit geschlossenen Zel-len, insbesondere Latex-Gummi, ausgebildet sein.

Die FR 2 887 034 zeigt die Verwendung eines aus einem Draht mit einem schraubenförmig gewickelten Federabschnitt ausgebildeten Federkontaktstift ohne Ummantelung. Dieser Federkontaktstift ist zwischen einem Substrat und einer Lötstelle einer Platine angeordnet. Der zuständige Prüfer hat dieses Dokument bezüglich des neben geordneten Patentanspruchs zitiert.

US 4,884,024 offenbart eine Vorrichtung zum Testen von Leiterplatten. Diese Vorrichtung ist mit Seitenwänden versehen, wobei an einer der Seitenwände eine Universalplatte welche Prüfstifte trägt mittels einer Angel Schwenkbar aufgehängt ist.

Aus der nachveröffentlichten internationalen Patentanmeldung WO 2009/047160 A2 geht eine Prüfvorrichtung zum Testen unbestückter Leiterplatten hervor, die eine Vollrasterkassette aufweist, in welcher Federkontaktstifte mittels einer Folie fixiert sind. Hierdurch kann die Vollrasterkassette beim Handhaben mit einer beliebigen Seite nach oben weisend gehalten werden, ohne dass die Federkontaktstifte herausfallen. Dies ist besonders von Vorteil in Verbindung mit einem Adapter, bei dem die Prüfnadeln nur gegenüber dem Herausfallen an einer Seite gesichert sind.

Die DE 39 06 691 A1 offenbart eine Prüfvorrichtung mit einer Haltevorrichtung, die eine starre Platte aufweist, in welche metallische Hülsen fest eingesetzt sind. Auf dieser Haltevorrichtung ist eine Kontaktierungsvorrichtung angeordnet, die gemäß einer Ausrichtungsform zwei Führungsplatten aufweist. In diesen Platten lagern Kontaktnadeln, die an ihren zur Haltevorrichtung weisenden Enden Hülsen aufweisen. Diese Hülsen verhindern, dass die Kontaktnadeln durch die Bohrungen in den Führungsplatten hindurchtreten können.

Der Erfindung liegt deshalb die Aufgabe zu Grunde, eine Kontaktierungseinheit für einen Paralleltester zum Testen einer unbestückten Leiterplatte zu schaffen, die gegenüber herkömmlichen Vorrichtungen eine bereichsweise höhere Dichte an Kontaktpunkten erlaubt und zudem für den zweiseitigen Test von Leiterplatten geeignet ist.

Die Aufgabe wird durch eine Kontaktierungseinheit mit den Merkmalen des Anspruchs 1 gelöst. Vorteilhafte Ausgestaltungen der Erfindung sind in den Unteransprüchen angegeben.

Die erfindungsgemäße Kontaktierungseinheit für eine Testvorrichtung zum Testen von Leiterplatten umfasst eine Vollrasterkassette und einen Adapter, wobei die Vollrasterkassette eine Vielzahl Federkontaktstifte aufweist, die im Raster von Kontaktstellen eines Grundrasters der Testvorrichtung angeordnet sind, und der Adapter Prüfnadeln aufweist, die zum elektrischen Verbinden jeweils von einem der Federkontaktstifte der Vollrasterkassette mit jeweils einem Leiterplattentestpunkt einer zu testenden Leiterplatte vorgesehen sind, wobei die Federkontaktstifte in der Vollrasterkassette nur gegen das Herausfallen auf der vom Adapter abgewandten Seite aber nicht gegen das Herausfallen von der dem Adapter zugewandten Seite und die Prüfnadeln im Adapter nur gegen das Herausfallen auf der von der Vollrasterkassette abgewandten Seite aber nicht gegen das Herausfallen von der der Vollrasterkassette zugewandten Seite gesichert sind, und der Adapter und die Vollrasterkassette lösbar derart miteinander verbunden sind, dass der Adapter und die Vollrasterkassette zu einer Kontaktierungseinheit fest miteinander verbunden sind.

Dadurch, dass die Vollrasterkassette und der Adapter lösbar miteinander verbunden sind, bilden sie im verbundenen Zustand eine handhabbare Kontaktierungseinheit, in welcher die Federkontaktstifte durch den Adapter vom Herausfallen aus der Vollrasterkassette an der zum Adapter weisenden Seite und die Prüfnadeln durch die korrespondierenden Federkontaktstifte in der Vollrasterkassette am Herausfallen aus dem Adapter in Richtung zur Vollrasterkassette weisenden Seite gesichert sind. Diese Kontaktierungseinheit kann also mit einer beliebigen Seite nach oben gehandhabt werden, ohne dass die Gefahr besteht einen der Federkontaktstifte bzw. eine der Prüfnadeln zu verlieren.

Weder in der Vollrasterkassette noch im Adapter sind Mittel notwendig, um die Federkontaktstifte bzw. die Prüfnadeln vor dem Herausfallen auf beiden Seiten der Vollrasterkassette bzw. des Adapters zu sichern. Sind die Vollrasterkassette und Adapter voneinander getrennt, dann können die Federkontaktstifte und die Prüfnadeln einfach ohne mechanischen Widerstand eingesetzt werden. Es müssen keine Sicherungsplatten vorgesehen sein, die die Federkontaktstifte bzw. die Prüfnadeln gegen ein Herausfallen an der Seite, von welcher sie in die Vollrasterkassette bzw. in den Adapter eingeführt worden sind. Derartige Sicherungsplatten sind im Stand der Technik zwar üblich, sie vermindern jedoch erheblich die maximale Dichte mit welcher die Federkontaktstifte und Prüfnadeln angeordnet werden können.

Mit der vorliegenden Erfindung ist es somit auf einfache Art und Weise möglich eine Kontaktierungseinheit zu schaffen, mit welcher die gewünschte hohe Dichte an Federkontaktstiften und Prüfnadeln erzielt werden kann.

Bei herkömmlichen Paralleltestern mit einer Vollrasterkassette und einem Adapter wurden die Vollrasterkassette und der Adapter unabhängig voneinander mittels Klemmeinrichtungen in der Prüfvorrichtung gehalten. Der Adapter wurde mittels Ausrichtstifte und korrespondierender Ausrichtlöcher auf der Vollrasterkassette ausgerichtet. Es gibt keine mechanische Verbindung zwischen dem Adapter und der Vollrasterkassette. Dies erlaubt den Austausch des Adapters unabhängig von der Vollrasterkassette. Die vorliegende Erfindung unterscheidet sich von dieser herkömmlichen Prüfvorrichtung dadurch, dass der Adapter und die Vollrasterkassette zu einer Kontaktierungseinheit fest miteinander verbunden sind. Die Kontaktierungseinheit wird als Einheit in die Prüfvorrichtung eingesetzt und ist als Einheit auszutauschen.

Beim bevorzugten Ausführungsbeispiel der vorliegenden Erfindung ist die lösbare Verbindung zwischen dem Adapter und der Vollrasterkassette durch ein Schwenkgelenk und eine Verriegelungseinrichtung ausgebildet. Im zusammengeklappten Zustand können die Vollrasterkassette oder der Adapter mittels der Verriegelungseinrichtung verriegelt werden, wodurch sie eine starre Einheit bilden. Im aufgeklappten Zustand sind die Seiten der Vollrasterkassette und des Adapters frei zugänglich auf welcher Federkontaktstifte bzw. Prüfnadeln in die Vollrasterkassette bzw. in den Adapter einführbar sind. Beschädigte Federkontaktstifte bzw. beschädigte Prüfnadeln können hier einfach ausgetauscht werden.

Im Rahmen der Erfindung ist es auch möglich, andere lösbare Verbindungsmittel als ein Schwenkgelenk in Kombination mit einer Verriegelungseinrichtung vorzusehen. Es kann auch zweckmäßig sein, lediglich mehrere Verriegelungs- und/oder Rasteinrichtungen zwischen dem Adapter und der Vollrasterkassette vorzusehen, so dass diese ohne Schwenkgelenk lösbar aneinander fixierbar sind.

Vorzugsweise sind die Federkontaktstifte ohne Ummantelung in der Vollrasterkassette angeordnet. Hierdurch lassen sich relativ einfach Vollrasterkassetten mit einer hohen Dichte an Federkontaktstiften erzielen. Weiterhin kann die Vollrasterkassette mit einem Spiel quer zur Axialerstreckung der Fenderkontaktstifte ausgebildet sein.

Die Prüfnadeln des Adapters sind vorzugsweise im wesentlichen geradlinig ohne schraubenförmige Wicklung ausgebildet und weisen eine Verdickung auf, um die Prüfnadeln gegen das Herausfallen in Richtung zu der zur testenden Leiterplatte weisenden Seite des Adapters zu sichern.

Die Erfindung wird nachfolgend anhand der Zeichnungen näher erläutert. In den Zeichnungen zeigen:
- Figur 1: einen Bereich eines Adapters in einer Schnittdarstellung zusammen mit einem angrenzenden Abschnitt einer Vollrasterkassette,
- Figur 2: einen Bereich der Vollrasterkassette aus Figur 1 zusammen mit einem Abschnitt des Adapters in einer Schnittdarstellung,
- Figur 3: einen Ausschnitt des Kontaktbereiches zwischen Kontaktnadeln des Adapters und Federkontaktstiften der Vollrasterkassette,
- Figur 4a, 4b, 4c: schematisch einen Schnitt durch eine Kontaktierungseinheit umfassend eine Vollrasterkassette und einen Adapter im aufgeklappten Zustand (Figur 4a, im zusammengeklappten unbelasteten Zustand (Figur 4b) und im zusammengeklappten, belasteten Zustand (Figur 4c),
- Figur 5: schematisch unterschiedliche Kontaktnadel und Kontaktstifte des Adapters zusammen mit einer zu testenden Leiterplatte,
- Figur 6a: schematisch einen Kontaktstift des Adapters mit Verriegelungsvorsprung und einigen Führungsplatten des Adapters,
- Figur 6b: schematisch einen Ausschnitt einer Führungsplatte mit einem Loch zur Aufnahme des Kontaktstiftes aus Figur 6a
- Figur 7: schematisch einen Endabschnitt eines Federkontaktstiftes mit zentrischer Federkontaktstelle, und
- Figur 8: einen Ausschnitt eines Grundrasters, das aus Modulen aufgebaut ist, in der Draufsicht.

Ein Paralleltester weist ein plattenförmiges Grundrasterelement 1 auf (Figur 2), das eine Vielzahl von Kontaktstellen in Form von Kontaktflächen besitzt, die in einem regelmäßigen Raster angeordnet sind. Diese Kontaktstellen des Grundrasterelements 1 sind jeweils mit einem Anschluss einer Auswerteelektronik verbunden. Das Grundrasterelement ist in der Regel aus mehreren streifenförmigen Segmenten ausgebildet.

Auf dem Grundrasterelement 1 ist eine Vollrasterkassette 2 angeordnet, die Federkontaktstifte 3 aufweist. Die Federkontaktstifte 3 der Vollrasterkassette 2 sind im gleichen Raster wie die Kontaktstellen des Grundrasterelementes 1 angeordnet, so dass jede Kontaktstelle des Grundrasterelementes 1 einen Federkontaktstift 3 berührt und elektrisch kontaktiert wird. Die Federkontaktstifte 3 sind parallel zueinander angeordnet.

Im vorliegenden Ausführungsbeispiel weist die Vollrasterkassette 2 eine Grundrasterplatte 4 und eine Adapterplatte 5 auf. Beide Platten 4, 5 besitzen eine Dicke von 7 mm. In der Adapterplatte 5 sind Durchgangsbohrungen 6 mit konstantem Querschnitt zur Aufnahme jeweils eines Federkontaktstiftes 3 ausgebildet. Der Durchmesser der Durchgangsbohrungen 6 beträgt etwa 0,75 mm.

In der Grundrasterplatte 4 sind auch Durchgangsbohrungen 7 angebracht. Diese Durchgangsbohrungen 7 weisen eine Ringstufe 8 auf, wobei der Durchmesser der Durchgangsbohrung 7 in den Abschnitt zwischen der Ringstufe und der zur Adapterplatte 5 weisenden Seite der Grundrasterplatte 4 dem Durchmesser der Durchgangsbohrungen 6 der Adapterplatte 5 entspricht und in dem Abschnitt von der Ringstufe 8 zu der zur Grundrasterplatte 1 weisenden Seite der Grundrasterplatte 4 etwas kleiner ist und zum Beispiel 0,6 mm beträgt.

Am Randbereich der beiden Platten 4, 5 sind mehrere Führungseinrichtungen 9 angeordnet. Die Führungseinrichtungen 9 sind jeweils aus zwei zueinander verschieblichen Zylinderhülsen ausgebildet, in welchen eine Schraubenfeder (nicht dargestellt) angeordnet ist. Die Führungseinrichtungen 9 sind kraft- und/oder formschlüssig mit den Platten 4, 5 verbunden. Die entsprechenden Bohrungen der Grundrasterplatte 4 und der Adapterplatte 5 sind so angeordnet, dass sie die beiden Platten 4, 5 ein Stück elastisch auseinander drücken. Wird die Vollrasterkassette 2 nicht von außen mit einem Druck belastet, so ergibt sich aufgrund der Führungseinrichtungen 9 ein Abstand zwischen den beiden Platten 4, 5 von etwa 2 bis 5 mm. Die Führungseinrichtungen 9 dienen somit dazu, die beiden Platten 4, 5 bei Belastung derart zu führen, dass sie im wesentlichen nur in Axialrichtung 10 der Federkontaktstifte 3 aufeinander zu bewegt werden.

Die Führungseinrichtungen 9 sind jedoch derart an den beiden Platten 4, 5 angeordnet bzw. ausgebildet, dass quer zur Axialrichtung 10 ein Bewegungsspiel zwischen der Grundrasterplatte 4 und der Adapterplatte 5 besteht. Die Federkontaktstifte 3 sind aus einem Draht mit einer Stärke von z.B. 0,12 mm gewickelt. Sie weisen einen Federabschnitt 11 auf, der sich über ein Großteil der Länge der Federkontaktstifte 3 erstreckt. Im Federabschnitt 11 sind die Federkontaktstifte 3 schraubenförmig gewickelt, wobei benachbarte Windungen zueinander beabstandet ausgebildet sind, so dass diese Federabschnitte eine elastische Federwirkung bereitstellen.

Der Federabschnitt 11 geht an dem zum Adapter weisenden Ende in einen sogenannten Trompetenabschnitt 12 über. Der Trompetenabschnitt 12 weist einige wenige Windungen auf, die ohne axialen Abstand ausgebildet sind. Somit ist der Trompetenabschnitt 12 starr. Er weist eine Verjüngung auf, die sich zum Ende hin wieder aufweitet. Hierdurch wird eine zum Adapter weisende Mulde ausgebildet. Diese Mulde dient zur Aufnahme der Enden von Kontaktnadeln bzw. Kontaktstiften des Adapters. Durch die Verjüngung hat der Trompetenabschnitt die Form einer Trompete, weshalb er auch so bezeichnet wird. Die Anmelderin bezeichnet derartige Federkontaktstifte mit Trompetenabschnitt auch als "Trompetenfedern".

An dem vom Trompetenabschnitt 12 entfernten Ende des Federabschnittes 11 geht der Federabschnitt 11 in eine Verdickungsstelle 13 über, die aus wenigen Windungen mit größerem Durchmesser als alle übrigen Windungen des Federkontaktstiftes 3 ausgebildet ist.

An die Verdickungsstelle 13 schließt sich ein Steckabschnitt 14 des Federkontaktstiftes 3 an. Im Steckabschnitt 14 besitzen die einzelnen Windungen jedoch einen kleineren Durchmesser als die Windungen des Federabschnittes 11 und sind ohne Abstand zueinander angeordnet, so dass der Steckabschnitt 14 steif ist. Der Federkontaktstift 3 weist somit am Übergang vom Federabschnitt 11 zum Steckabschnitt 14 eine Verjüngungsstelle bzw. Stufe auf, die an der Ringstufe 8 der Durchgangsbohrung 7 anschlägt und den Federkontaktstift 3 gegen das Herausfallen aus der Vollrasterkassette in Richtung zur Grundrasterplatte 1 hindert. Bzgl. der von der Grundrasterplatte weg weisenden Richtung ist der Federkontaktstift 3 in der Vollrasterkassette frei beweglich.

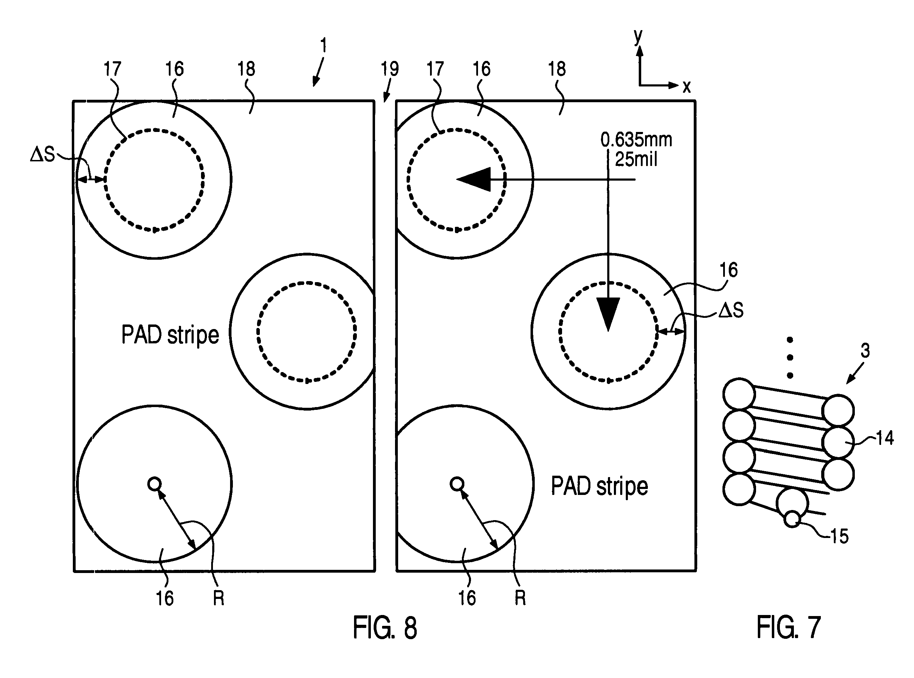

Am zur Grundrasterplatte 1 weisenden Ende des Steckabschnittes 14 ist der Federkontaktstift 3 etwas verjüngt ausgebildet, wobei der letzte Windungsabschnitt mit einem kleineren Radius als die benachbarten Windungen gebogen ist, so dass der Draht des Federkontaktstiftes 3 ein Ende aufweist, das etwa mittig bezüglich der benachbarten Windungen angeordnet ist. Hierdurch wird eine zentrische Federkontaktstelle 15 ausgebildet (Figur 2, Figur 8).

Figur 8 zeigt in der Draufsicht einen Ausschnitt eines Grundrasters mit kreisförmigen Kontaktfeldern 16. Dieses Grundraster sind zwei ineinander verschränkte quadratische Raster. Ein jedes quadratisches Raster hat einen Rasterabstand von 50 mil. Die beiden Raster sind jeweils in X- und Y-Richtung um einen halben Rasterabstand (= 25 mil) zueinander versetzt.

Bei herkömmlichen Federkontaktstiften liegt die Kontaktstelle außerhalb des Zentrums des Federkontaktstiftes auf einer Kreislinie, die in Figur 8 schematisch durch die Kreislinie 17 angedeutet ist. Bei einer nicht exakt mittigen Ausrichtung des Federkontaktstiftes bezüglich des entsprechenden Kontaktfeldes besteht die Gefahr, dass der Federkontaktstift das Grundrasterelement außerhalb der Kontaktstelle kontaktiert, wodurch kein elektrischer Kontakt erzeugt werden würde. Bei einer exzentrischen Anordnung der Kontaktstelle kann eine Fehlkontaktierung bereits bei einem Versatz um den Abstand zwischen der Kreislinie 17 und dem äußeren Rand des Kontaktfeldes 16 (= Δs) verursacht werden.

Bei einer zentrischen Anordnung der Federkontaktstelle 15 an dem Federkontaktstift 3 kontaktiert der Federkontaktstift 3 bei perfekter Ausrichtung ein Kontaktfeld 16 exakt im Zentrum. Die Toleranz, ab der die Gefahr einer Fehlkontaktierung besteht, beträgt damit den vollen Radius R des entsprechenden Kontaktfeldes 16 und ist damit um ein Vielfaches größer als die Toleranz Δs bei exakter Anordnung herkömmlicher Federkontaktstifte.

Dies ist insbesondere von Vorteil, wenn das Grundraster aus mehreren Modulen 18 ausgebildet ist. Zwischen den Modulen befinden sich jeweils Stoßkanten 19. Im Bereich der Stoßkanten 19 der Module sind aus fertigungstechnischen Gründen die Kontaktfelder 16 etwas abgeschnitten, so dass hier die Toleranz für einen Versatz der Federkontaktstifte bezüglich der Kontaktfeder 16 nochmals verringert wird. Im Bereich der Stoßkanten 19 ist die Gefahr einer Fehlkontaktierung mit einer exzentrischen Kontaktstelle nochmals wesentlich größer.

Die in Figur 8 gezeigten Kontaktfelder weise einen Durchmesser D von 0,635 mm bzw. einen Radius von 0,317 mm auf. Die optimal erreichbare Toleranz beträgt somit 0,317 mm. Bei herkömmlichen Federstiften hat die Kreislinie 17 einen Durchmesser von 0,4 mm (r=0,2 mm). Die Toleranz beträgt hier nur noch 0,117 mm. Wenn die Kontaktfelder 16 an den Stoßkanten abgeschnitten sind, dann reduziert sich die Toleranz auf 0,06 mm.

Die Grundrasterplatte 4 und die Adapterplatte 5 sind aus einem faserfreien Kunststoffmaterial ausgebildet. Hierdurch erhalten die Durchgangsbohrungen 6, 7 eine glatte Oberfläche, die das Einführen der Federkontaktstifte erleichtert. Ein geeignetes Kunststoffmaterial ist z.B. Polyetheretherketon (PEEK) im vorliegenden Ausführungsbeispiel weisen die beiden Platten 4, 5 eine Dicke von 7 mm auf. Plattendicken von 5 bis 10 mm sind sinnvoll.

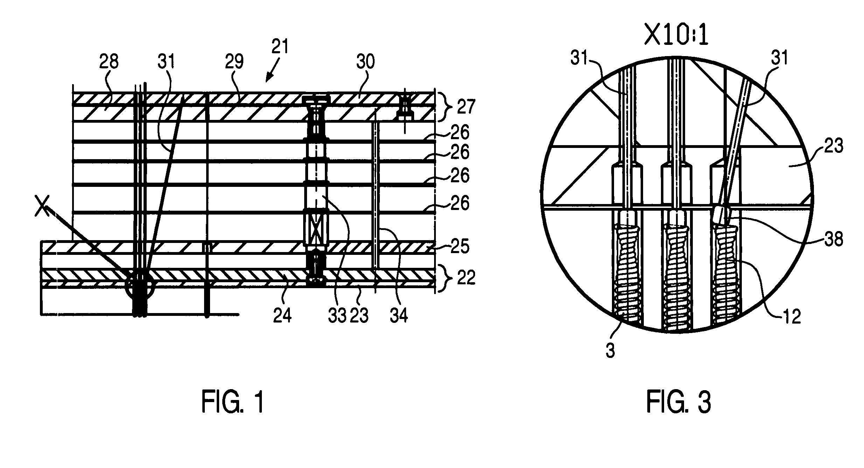

Die elektrische Verbindung zwischen den im regelmäßigen Raster angeordneten Federkontaktstiften und den unregelmäßig angeordneten Kontaktstellen einer zu testenden Leiterplatte, die im folgenden als Leiterplattentestpunkte bezeichnet werden, wird über einen Adapter 21 hergestellt. Der Adapter 21 ist aus mehreren parallel zueinander angeordneten Führungsplatten ausgebildet (Fig. 1). Benachbart zur Vollrasterkassette 2 ist ein Plattenpaket mit zwei Platten angeordnet, das Bohrungen im Muster der Anordnung der Federkontaktstifte der Vollrasterkassette bzw. der Kontaktstellen des Grundrasters aufweist. Dieses Plattenpaket wir im folgenden als Grundraster-Einheit 22 bzw. GR-Einheit 22 bezeichnet. Die GR-Einheit 22 ist aus einer Deckplatte 23 und einer Strukturplatte 24 zusammengesetzt. Die Deckplatte ist unmittelbar angrenzend zur Vollrasterkassette 2 angeordnet und weist eine Dicke von 1,5 mm auf. Die Strukturplatte 24 liegt an der Deckplatte 23 an. Sie weist eine Dicke von 3 mm auf und verleiht dem Adapter an der zur Vollrasterkassette weisenden Seite die notwendige mechanische Festigkeit.

Mit etwas Abstand zur Strukturplatte 24 ist eine Halteplatte 25 angeordnet. Die Halteplatte weist eine Stärke von 3 mm auf.

Vier dünne Führungsplatten 26 sind mit Abstand zueinander angeordnet. Sie weisen jeweils eine Dicke von 0,3 mm auf. An der zur Leiterplatte weisenden Seite des Adapters 21 ist eine Platteneinheit mit drei Platten vorgesehen, die im folgenden als Leiterplatteneinheit bzw. LP-Einheit 27 bezeichnet wird. Die LP-Einheit ist aus einer Strukturplatte 28, einer Führungsplatte 29 und einer Deckplatte 30 zusammengesetzt. Die Strukturplatte 28 verleiht der LP-Einheit 27 die notwendige mechanische Festigkeit. Diese Strukturplatte ist mit einer Dicke von 4 mm ausgebildet.

Die Deckplatte 23 und die Deckplatte 30 sind außerhalb des Testfeldes mit den übrigen Platten des Adapters verschraubt. Diese Schraubverbindungen können somit nicht die elektrischen Eigenschaften des Adapters beeinflussen.

Die Führungsplatte 29 ist wiederum eine dünne Führungsplatte mit einer Dicke von 0,3 mm. In einer derart dünnen Platte können die Bohrungen zum Führen der Kontaktnadeln und Kontaktstifte einfacher mit einer hohen Präzision als in den dicken Struktur- und Halteplatten eingebracht werden. Die Führungsplatte 29 bzw. die Deckplatte 30 weist ein Bohrmuster auf, das dem Muster der Leiterplattentestpunkte entspricht und stellt somit sicher, dass die Prüfnadeln des Adapters 21 exakt auf die Leiterplattentestpunkte ausgerichtet sind.

Alle Platten mit Ausnahme der Deckplatten 23, 30 werden von mehreren an sich bekannten Säulenmechanismen 33 auf Abstand gehalten. Zwischen der GR-Einheit 22 und der LP-Einheit 27 erstrecken sich Ausrichtstifte 34, die jeweils ein Loch in der Halteplatte 25 und den Führungsplatten 26 formschlüssig durchgreifen, so dass die Platten 25, 26 exakt zueinander ausgerichtet sind.

Der Adapter 21 kann als Prüfnadeln sowohl Kontaktnadeln 31 als auch Kontaktstifte 32 aufweisen. Die Kontaktnadeln 31 dienen zum Kontaktieren von Padfeldern auf der zu testenden Leiterplatte. Die Kontaktstifte 32 sind zum Kontaktieren von Durchkontaktierungen 37 der Leiterplatte 35 vorgesehen.

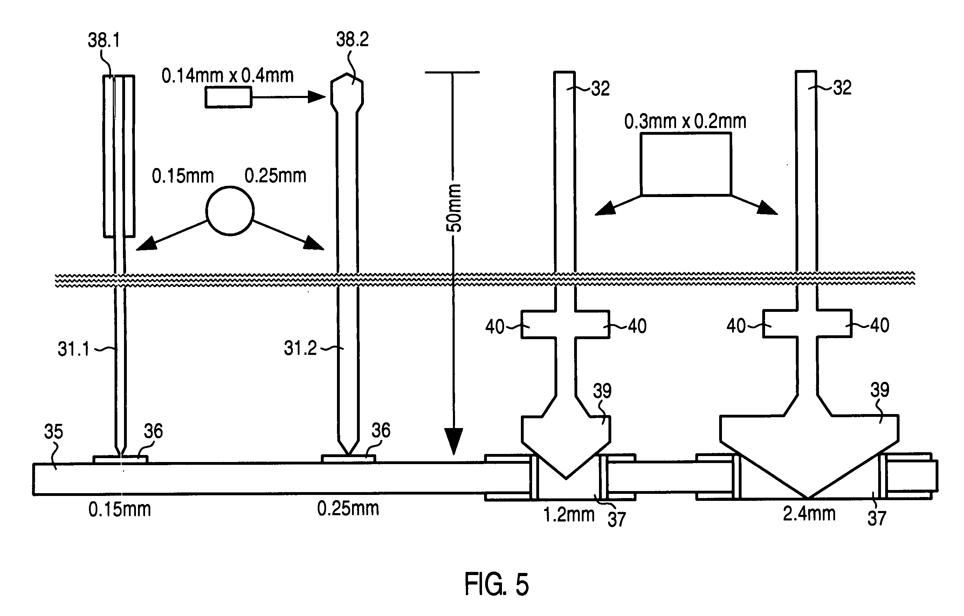

Die Kontaktnadeln 31 können mit unterschiedlichen Durchmessern ausgebildet sein. Im vorliegenden Ausführungsbeispiel sind Kontaktnadeln 31.1 mit einem Durchmesser von 0,15 mm und Kontaktnadeln 31.2 mit einem Durchmesser von 0,25 mm vorgesehen (Fig. 5). Diese Kontaktnadeln 31 weisen jeweils einen kreisförmigen Querschnitt auf. Sie sind an ihren zur Vollrasterkassette weisenden Enden jeweils mit einer Verdickung 38 versehen. Diese Verdickung 38 kann einerseits durch eine aufgesteckte bzw. aufgeschrumpfte Hülse 38.1 oder durch eine Quetschung 38.2 der Kontaktnadel 31.2 ausgebildet sein. Eine Quetschung ist einfacher und kostengünstiger herstellbar. Sie erfordert jedoch eine gewisse Materialstärke der Kontaktnadel und ist vor allem für dickere Kontaktnadeln geeignet. Bei dünneren Kontaktnadeln ist es zweckmäßiger eine zusätzliche Hülse 38.1 vorzusehen.

In der Deckplatte 23 sind Stufenbohrungen zur Aufnahme der Quetschungen 38.2 der Kontaktnadeln 31.2 und in der Halteplatte 25 sind Stufenbohrungen zur Aufnahme der Hülsen 38.1 vorgesehen (Fig. 3). Diese Stufenbohrungen dienen jeweils dazu, dass die Kontaktnadeln 31 mit ihrer Verdickung 38 nicht durch die jeweilige Platte 23, 25 hindurchbewegt werden können und somit gegen ein Herausfallen in Richtung zur Seite der zu testenden Leiterplatte gesichert sind. Die Kontaktnadeln 31 sind in Richtung zur Vollrasterkassette 2 frei beweglich im Adapter 21 gelagert.

Mit derartigen Kontaktnadeln 31 ist es grundsätzlich auch möglich, auf der Oberfläche der Leiterplatte 35 befindlichen Randbereiche der Durchkontaktierungen 37 zu kontaktieren. Jedoch hat die Erfahrung gezeigt, dass die Versätze von Padfeldern 36 und Durchkontaktierungen 37 aufgrund der unterschiedlichen Fertigungsverfahren voneinander unabhängig sind. Dies heißt, dass in der Regel alle Padfelder 36 einen bestimmten Versatz bezüglich ihrer Idealposition um einen vorbestimmten Betrag und eine vorbestimmte Richtung aufweisen und alle Durchkontaktierungen einen anderen Versatz um eine vorbestimmte Richtung und einen vorbestimmten Betrag aufweisen. Die Kontaktnadeln 31 sind sehr präzise auf die kleinen Padfelder 36 auszurichten und zu justieren.

Die speziell zum Kontaktieren der Durchkontaktierungen 37 ausgebildeten Kontaktstifte 32 besitzen an ihren zur Leiterplatte 35 weisenden Enden einen verbreiterten Tastkopf 39 (Fig. 5). Dieser Tastkopf 39 ist mit einer zur Leiterplatte 35 weisenden dreieckförmigen Spitze ausgebildet. Hierdurch ist es möglich, die Durchkontaktierung 37 sicher zu kontaktieren, auch wenn die Kontaktstifte 32 bezüglich der Durchkontaktierungen 37 nicht mit der Präzision ausgerichtet sind, mit der die Kontaktnadeln 31 bezüglich der Padfelder 36 ausgerichtet sind. Somit ist es möglich, eine sichere Kontaktierung aller Leiterplattentestpunkt 36, 37 zu erzielen, auch wenn die Ausrichtung des Adapters 21 bzgl. der Leiterplatte 35 vor allem bezüglich der Kontaktnadeln 31 und der entsprechenden Padfelder 36 erfolgt.

Die Kontaktstifte 32 gemäß dem vorliegenden Ausführungsbeispiel sind aus einem dünnen Blech mit einer Dicke von z.B. 0,2 mm gefertigt. Auch die Tastköpfe 39 sind ebenflächig aus dem Blech ausgebildet.

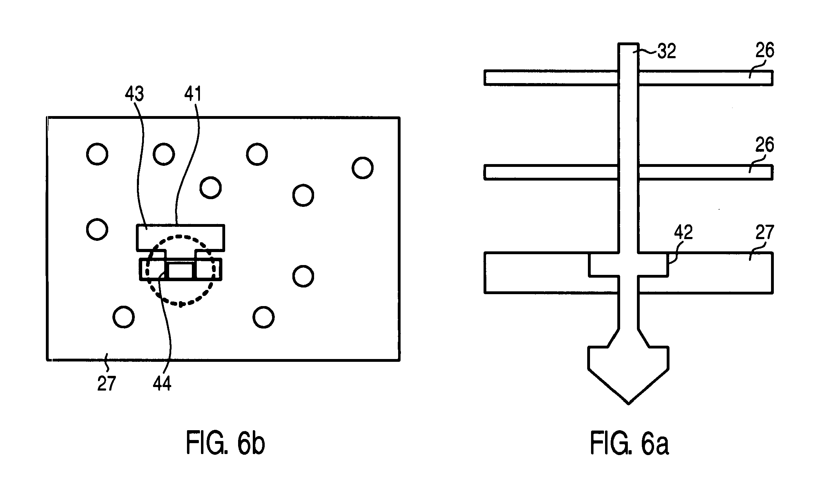

Mit geringfügigem Abstand benachbart zu den Tastköpfen 39 sind an den Kontaktstiften 32 Verriegelungsvorsprünge 40 vorgesehen (Figur 5, 6a).

Zur Aufnahme der Kontaktstifte 32 sind in der LP-Einheit 27 spezielle Löcher eingebracht, die im folgenden als Schlüssellöcher 41 bezeichnet werden. Diese Schlüssellöcher weisen eine Größe auf, dass man den Kontaktstift 32 zusammen mit seinem Verriegelungsvorsprung 40 bzw. seinen Verriegelungsvorsprüngen 40 hindurchführen kann. Angrenzend zum Schlüsselloch 41 kann auf der von der Leiterplatte weg weisenden Seite der LP-Einheit 27 eine Ausnehmung 42 zur Aufnahme des Verriegelungsvorsprunges 40 ausgebildet sein. Bei dem in Figur 6b dargestellten Ausführungsbeispiel ist das Schlüsselloch 41 in der Draufsicht T-förmig ausgebildet, so dass der Kontaktstift zusammen mit seinem Verriegelungsvorsprung 40 durch den "Querbalken 43 des T" hindurchgeführt werden kann, wobei er danach mit dem schmalen Abschnitt des Kontaktstiftes 32 im Bereich zwischen dem Verriegelungsvorsprung 40 und dem Tastkopf 39 entlang dem "Stamm 44 des T" verschoben wird. An dem vom Querbalken 43 entfernten Ende des Stammes 44 ist angrenzend die Ausnehmung 42 zur Aufnahme des Vorriegelungsvorsprunges 40 angeordnet. In diese Ausnehmung 42 wird der Verriegelungsvorsprung eingesetzt, so dass der Kontaktstift daran gehindert ist, sich zurück zum Querbalken 43 zu bewegen und er an der zur Leiterplatte weisenden Seite nicht aus dem Adapter 21 fallen kann.

Die Ausnehmung 40 ist in der Strukturplatte 28 der LP-Einheit 27 ausgebildet.

Im Rahmen der Erfindung kann das Schlüsselloch 41 und die Ausnehmung 42 selbstverständlich auch andere Formen aufweisen. So kann das Schlüsselloch 41 als Langloch ausgebildet sein und die Ausnehmung 42 in der Draufsicht senkrecht zum Langloch verlaufen. Der Kontaktstift 32 ist dann nach dem Hindurchführen des bzw. der Verriegelungsvorsprünge 40 im Schlüsselloch 41 um 90° zu drehen, so dass die Verriegelungsvorsprünge 40 in der Ausnehmung zum Liegen kommen.

Das Schlüsselloch 41 kann auch ohne entsprechende Ausnehmung ausgebildet sein. Die Führungslöcher in den weiteren Führungsplatten 26 sind dabei derart angeordnet, dass sie den Kontaktstift 32 derart führen, dass er durch das Schlüsselloch 41 an einer Stelle tritt, die so schmal ist, dass der bzw. die Verriegelungsvorsprünge 40 auf der Führungsplatte 27 aufliegen. Bei dem in Figur 6b gezeigten T-förmigen Schlüsselloch ist diese Position, die die Idealposition des Kontaktstiftes 32 darstellt, im Bereich des Stammes 44. Zum Einführen bzw. Herausnehmen muss der Kontaktstift 32 gebogen werden, um die Verriegelungsvorsprünge 40 durch den Balken 43 durch das T-förmige Schlüsselloch 41 zu führen.

Die Kontaktstifte 32 im Adapter 21 sind im wesentlichen senkrecht zu den einzelnen Platten 23 - 30 ausgerichtet. Die Kontaktnadeln 31 hingegen werden vielfach schräg verlaufend im Adapter 21 angeordnet. Hierdurch ist es möglich, die nicht im Raster angeordneten Kontaktstellen der zu testenden Leiterplatte zu kontaktieren und in lokal begrenzten Bereichen auf der Seite der zu testenden Leiterplatte viele Kontaktnadeln 31 mit ihren Enden anzuordnen, um eine hohe Kontaktdichte bereitzustellen. Auf der gegenüberliegenden zur Vollrasterkassette 2 weisenden Seite sind die Enden dieser Kontaktnadeln über einen wesentlich größeren Bereich verteilt, in dem sie eine Vielzahl von Federkontaktstiften 3 kontaktieren. Es besteht daher der Wunsch, die Kontaktnadeln 31 möglichst schräg anzuordnen. Der Schrägstellung der Kontaktnadeln 1 sind mechanisch prinzipiell keine Grenzen gesetzt. Jedoch verursacht eine jede Schrägstellung einer Kontaktnadel 31 eine Verkürzung in Axialrichtung, wobei als Axialrichtung die Richtung senkrecht zu den Platten 23 - 30 verstanden wird. Diese Längendifferenz in Axialrichtung wird durch die Federkontaktstifte 3 ausgeglichen.

Die Vollrasterkassette 2 und der Adapter 21 sind mittels eines Schwenkgelenkes 20 mechanisch miteinander verbunden. Das Schwenkgelenk 20 ist am Rand der Adapterplatte 5 der Vollrasterkassette 2 bzw. am Rand der GR-Einheit 22 des Adapters 21 befestigt. Das Schenkgelenk ist vorzugsweise lösbar ausgebildet. Das Lösen des Schwenkgelenkes erfolgt bspw. durch eine geradlinige Bewegung das Adapters bzgl. der Vollrasterkassette in Richtung der Schwenkachse. Hierdurch kann die Vollrasterkassette 2 einfach mit einem anderen Adapter 21 kombiniert werden.

An dem dem Schwenkgelenk 20 gegenüberliegenden Rand der Adapterplatte 5 der Vollrasterkassette 2 bzw. am Rand der GR-Einheit 22 des Adapters 21 ist eine Verriegelungseinrichtung umfassend zumindest einen Verriegelungszapfen 49 und eine Zapfenaufnahme 50 ausgebildet. Der Verriegelungszapfen 49 ist beim vorliegenden Ausführungsbeispiel an der Vollrasterkassette 2 und die Zapfenaufnahme 50 am Adapter 21 ausgebildet. Der Verrieglungszapfen 49 weist eine Kerbe 51 auf, in welche in der Zapfenaufnahme 50 ein Riegel (nicht dargestellt) lösbar eingreifen kann, um den Verriegelungszapfen 49 in der Zapfenaufnahme 50 zu fixieren.

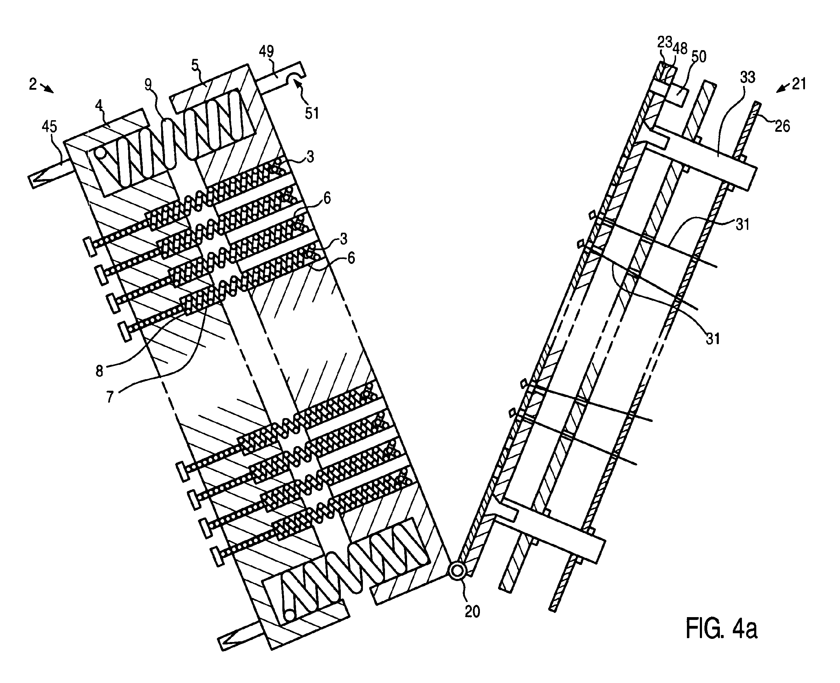

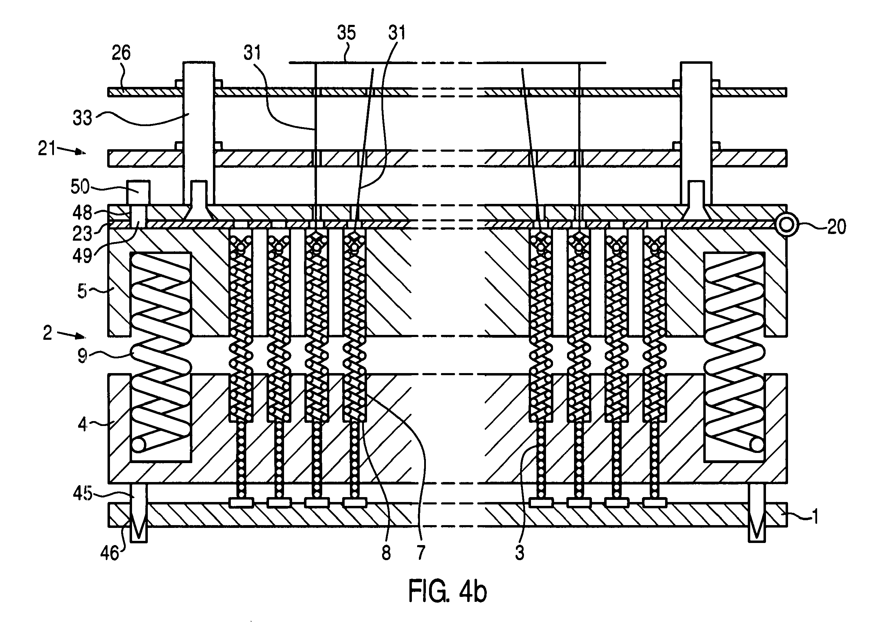

In Figur 4a ist sehr grob schematisch vereinfacht die Kontaktierungseinheit umfassend die Vollrasterkassette 2 und den Adapter 21 im aufgeklappten Zustand dargestellt. Fig. 4b zeigt die Kontaktierungseinheit im zusammengeklappten Zustand. Die Vollrasterkassette 2 und der Adapter 21 sind mittels der Verriegelungseinrichtung 49, 50 miteinander fixiert. Hierdurch ist jeweils eine der Prüfnadeln 31 auf einem der Federkontaktstifte 3 angeordnet, so dass sie sich gegenseitig gegen ein Herausfallen aus der Kontaktierungseinheit blockieren. Diese Kontaktierungseinheit kann daher im verriegelten Zustand beim Handhaben mit einer beliebigen Seite nach oben gehalten werden, ohne dass weder ein Prüfstift noch eine Prüfnadel herausfallen kann. Beim Zusammenklappen werden die Vollrasterkassette 2 und der Adapter 21 vorzugsweise so geführt, dass sich im Moment des Zusammentreffens der beiden einander zugewandten Flächen der Vollrasterkassette 2 und des Adapters 21 diese vertikal ausgerichtet sind, so dass weder die Federkontaktstifte 3 noch die Kontaktnadeln 31 herausfallen können.

In Figur 4b ist die Kontaktierungseinheit unbelastet auf der Prüfvorrichtung aufgesetzt, das heißt, dass die Grundrasterplatte 4 und die Adapterplatte 5 durch die Führungseinrichtung 9 ein Stück auseinander gedrückt sind und die Federkontaktstifte 3 entspannt in den Durchgangsbohrungen 6, 7 lagern. Die Grundrasterplatte 4 ist mit mehreren Ausrichtstiften 45 versehen und mit Ausrichtbohrungen 46 des Grundrasterelements 1 der Prüfvorrichtung in Eingriff. Die Adapterplatte 5 ist mit dem schwenkgelenk 20 fest mit der GR-Einheit 22 des Adapters verbunden, wodurch die Vollrasterkassette 2 bzgl. des Adapters 21 ausgerichtet ist. Die Kontaktnadeln 31 sind mit ihren Verdickungen in den Mulden der Trompetenabschnitte 12 der entsprechenden Federkontaktstifte 3 aufgenommen. Die schräg gestellten Kontaktnadeln 31 sind mit Abstand zu der zu testenden Leiterplatte 35 angeordnet.

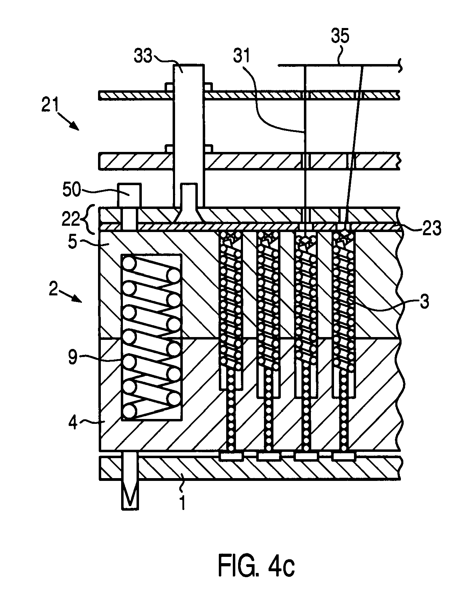

Wird nun diese Kontaktanordnung belastet, das heißt durch eine entsprechende Presse zusammengedrückt, so werden in der Vollrasterkassette 2 die Grundrasterplatte 4 und die Adapterplatte 5 entgegen der Federwirkung der Führungseinrichtungen 9 zusammengedrückt. Hierdurch werden die Federkontaktstifte 3 in Richtung zum Adapter 21 gedrückt. Sie liegen dann mit Federspannung an den Kontaktnadeln 31 an. Die Kontaktnadeln 31 werden dann in Richtung zur testenden Leiterplatte 35 gedrückt, so dass alle Kontaktnadeln 31 die entsprechenden Leiterplattentestpunkte kontaktieren. In Figur 4c kann man gut die unterschiedlichen Niveaus der Berührungsstellen zwischen Kontaktnadeln und Federkontaktstiften sehen, die schräg gestellt bzw. nicht schräg gestellt sind.

Die Federkontaktstifte 3, denen keine Kontaktnadel 31 bzw. kein Kontaktstift 32 zugeordnet ist, werden gegen die Deckplatte 23 des Adapters 21 gedrückt. Die Deckplatte 23 deckt zudem auch die Schraubenelemente ab, mit welchen die Säulenmechanismen 33 im Adapter befestigt sind. Die Deckplatte 23 stellt somit sicher, dass keine unerwünschten elektrischen Kontakte zwischen nicht verwendeten Federkontaktstiften 3 und anderen Elementen des Adapters hergestellt werden können.

Weiterhin ist anzumerken, dass die Ausrichtstifte 45 der Grundrasterplatte 4 und die Ausrichtstifte 47 der Adapterplatte 5 voneinander unabhängig sind, so dass die Grundrasterplatte 4 und die Adapterplatte 5 unabhängig voneinander bezüglich des Grundrasterelementes 1 bzw. bezüglich des Adapters 21 ausgerichtet werden können. Diese unabhängige Ausrichtung wird zudem durch das Bewegungsspiel zwischen der Grundrasterplatte 4 und der Adapterplatte 5 ermöglicht. Dieses Bewegungsspiel wird zum Einen durch die Führungseinrichtungen 9 und zum Anderen dadurch realisiert, dass die Federkontaktstifte 3 sich über den Zwischenbereich zwischen der Grundrasterplatte 4 und der Adapterplatte 5 ohne Stahlhülse erstrecken und so in Querrichtung zu ihrer Axialrichtung 10 beweglich sind.

Die Erfindung ist oben anhand eines Ausführungsbeispiels beschrieben, bei dem die Vollrasterkassette und der Adapter mittels eines Gelenkes miteinander verbunden sind. Im Rahmen der Erfindung ist es auch möglich, eine beliebige, lösbare mechanische Verbindung zwischen der Vollrasterkassette und dem Adapter vorzusehen. Es können z.B. auch mehrere an zumindest zwei gegenüberliegenden Seiten der Randbereiche der Vollrasterkassetten und der Adapter angeordnete Verriegelungs- oder Rasteinrichtungen sein, so dass der Adapter auch vollständig von der Vollrasterkassette gelöst werden kann.

Die Erfindung betrifft eine Kontaktierungseinheit für eine Testvorrichtung zum Testen von Leiterplatten. Die Kontaktierungseinheit umfasst eine Vollrasterkassette und einen Adapter. Die Vollrasterkassette weist eine Vielzahl Federkontaktstifte auf, die im Raster von Kontaktstellen eines Grundrasters einer Testvorrichtung angeordnet sind. Der Adapter weist Prüfnadeln auf, die zum elektrischen Verbinden jeweils von einem der Federkontaktstifte der Vollrasterkassette mit jeweils einem Leiterplattentestpunkt einer zu testenden Leiterplatte vorgesehen sind, wobei die Federkontaktstifte in der Vollrasterkassette gegen das Herausfallen auf der vom Adapter abgewandten Seite und die Prüfnadeln im Adapter gegen das Herausfallen auf der von der Vollrasterkassette abgewandten Seite gesichert sind. Der Adapter und die Vollrasterkassette sind lösbar miteinander verbunden. Hierdurch sind im zusammengesetzten Zustand des Adapters und der Vollrasterkassette sowohl die Federkontaktstifte als auch die Prüfnadeln vor dem Herausfallen aus der Kontaktierungseinheit gesichert.

**Bezugszeichenliste**

| | | | |
|---|---|---|---|
| 1 | Grundrasterelement | 25 | Halteplatte |
| 2 | Vollrasterkassette | 26 | Führungsplatte |
| 3 | Federkontaktstift | 27 | LP-Einheit |
| 4 | Grundrasterplatte | 28 | Strukturplatte |
| 5 | Adapterplatte | 29 | Führungsplatte |
| 6 | Durchgangsbohrung der Adapterplatte | 30 | Deckplatte |
| | | 31 | Kontaktnadel |
| 7 | Durchgangsbohrung der Grundrasterplatte | 32 | Kontaktstift |
| | | 33 | Säulenmechanismus |
| 8 | Ringstufe | 34 | Ausrichtstift |
| 9 | Führungseinrichtung | 35 | Leiterplatte |
| 10 | Axialrichtung der Federkontaktstifte | 36 | Padfeld |
| | | 37 | Durchkontaktierung |
| 11 | Federabschnitt | 38 | Verdickung |
| 12 | Trompetenabschnitt | 39 | Tastkopf |
| 13 | Verdickungsstelle | 40 | Verriegelungsvorsprung |
| 14 | Steckabschnitt | 41 | Schlüsselloch |
| 15 | zentrische Federkontaktstelle | 42 | Ausnehmung |
| 16 | Kontaktfeld des Grundrasters | 43 | Querbalken |
| 17 | Kreislinie | 44 | Stamm |
| 18 | Modul | 45 | Ausrichtstift |
| 19 | Stoßkante | 46 | Ausrichtbohrung |
| 20 | Schwenkgelenk | 47 | Ausrichtstift |
| 21 | Adapter | 48 | Ausrichtbohrung |
| 22 | GR-Einheit | 49 | Verriegelungszapfen |
| 23 | Deckplatte | 50 | Zapfenaufnahme |
| 24 | Strukturplatte | 51 | Kerbe |

## Patentansprüche

1. Kontaktierungseinheit für eine Testvorrichtung zum Testen von Leiterplatten, umfassend eine Vollrasterkassette (2) und einen Adapter (21), wobei die Vollrasterkassette (2) eine Vielzahl Federkontaktstifte (3) aufweist, die im Raster von Kontaktstellen eines Grundrasters der Testvorrichtung angeordnet sind, und der Adapter (21) Prüfnadeln (31, 32) aufweist, die zum elektrischen Verbinden jeweils von einem der Federkontaktstifte (3) der Vollrasterkassette (2) mit jeweils einem Leiterplattentestpunkt einer zu testenden Leiterplatte vorgesehen sind, wobei die Prüfnadeln (31, 32) im Adapter (21) nur gegen das Herausfallen auf der von der Vollrasterkassette abgewandten Seite aber nicht gegen das Herausfallen von der der Vollrasterkassette zugewandten Seite gesichert sind, und der Adapter (21) und die Vollrasterkassette (2) lösbar miteinander derart verbunden sind, dass der Adapter (21) und die Vollrasterkassette (2) zu einer Kontaktierungseinheit fest miteinander verbunden sind, **dadurch gekennzeichnet, dass** die Federkontaktstifte in der Vollrasterkassette nur gegen das Herausfallen auf der vom Adapter (21) abgewandten Seite aber nicht gegen das Herausfallen von der dem Adapter zugewandten Seite gesichert sind.

2. Kontaktierungseinheit nach Anspruch 1,
**dadurch gekennzeichnet,**
**dass** die lösbare Verbindung zwischen dem Adapter (21) und der Vollrasterkassette (2) eine Rast- und/oder Verriegelungseinrichtung ist.

3. Kontaktierungseinheit nach Anspruch 1 oder 2,
**dadurch gekennzeichnet,**
**dass** die lösbare Verbindung zwischen dem Adapter (21) und der Vollrasterkassette (2) durch ein Schwenkgelenk (20) und eine Verriegelungseinrichtung (49, 50) ausgebildet ist, wobei das Schwenkgelenk (20) am Rand der einander zugewandten Flächen des Adapters (21) und der Vollrasterkassette (2) angeordnet ist, so dass die Kontaktierungseinheit bestehend aus dem Adapter und der Vollrasterkassette (2) aufklappbar ist und im zusammengeklappten Zustand die Vollrasterkassette und der Adapter (21) mittels der Verriegelungseinrichtung (49, 50) verriegelbar sind.

4. Kontaktierungseinheit nach Anspruch 3,
**dadurch gekennzeichnet,**
**dass** das Schwenkgelenk lösbar ausgebildet ist.

5. Kontaktierungseinheit nach einem der Ansprüche 1 bis 4,
**dadurch gekennzeichnet,**
**dass** die Federkontaktstifte (3) jeweils aus einem Draht mit einem schraubenförmig gewickelten Federabschnitt ausgebildet sind und ohne Ummantelung in der Vollrasterkassette (2) angeordnet sind.

6. Kontaktierungseinheit nach Anspruch 5,
**dadurch gekennzeichnet,**
**dass** die Federkontaktstifte (3) aus jeweils einem Draht schraubenförmig gewickelt sind und der maximale Durchmesser eines jeden der Federkontaktstifte(3) nicht größer als 0,8 mm ist und an ihrem zum Grundraster weisenden Ende der Federkontaktstifte die endseitige Windung des Drahtes jeweils mit einem geringeren Radius als benachbarte Windungen gewickelt ist, so dass der Draht ein Ende aufweist, das mittig bezüglich der benachbarten Windungen angeordnet ist und eine zentrische Kontaktstelle (15) bildet.

7. Kontaktierungseinheit nach Anspruch 5 oder 6,
**dadurch gekennzeichnet,**
**dass** die Federkontaktstifte (3) an ihren zum Adapter weisenden Enden jeweils einen Trompetenabschnitt (12) aufweist, der einige Windungen aufweist, die ohne axialen Abstand ausgebildet sind, und eine Verjüngung aufweist, die sich zum Ende hin wieder aufweitet, so dass eine zum Adapter weisende Mulde ausgebildet ist.

8. Kontaktierungseinheit nach einem der Ansprüche 1 bis 7,
**dadurch gekennzeichnet,**
**dass** die Prüfnadeln (31) des Adapters (21) im wesentlichen geradlinig ohne schraubenförmige Wicklung ausgebildet sind und eine Verdickung (38) aufweisen, um die Prüfnadeln gegen das Herausfallen an der zur testenden Leiterplatte weisenden Seite des Adapters sichern.

9. Kontaktierungseinheit nach einem der Ansprüche 1 bis 8,
**dadurch gekennzeichnet,**
**dass** die Vollrasterkassette aus einer zum Adapter (21) weisend angeordneten Adapterplatte (5) und einer zum Grundraster weisend angeordneten Grundrasterplatte (4) ausgebildet ist, und eine Führungseinrichtung (9) zwischen der Adapterplatte (5) und der Grundrasterplatte (4) derart ausgebildet ist, dass die Adapterplatte (5) und die Grundrasterplatte (4) in Axialrichtung der Federkontaktstifte (3) relativ zueinander bewegbar sind und in der Ebene quer zur Axialrichtung (10) der Federkontaktstifte (3) ein Bewegungsspiel aufweisen.

10. Kontaktierungseinheit nach einem der Ansprüche 1 bis 9,
**dadurch gekennzeichnet,**
**dass** die Prüfnadeln des Adapters (21) Kontaktnadeln (31) und/oder Kontaktstifte (32) umfassen.

11. Kontaktierungseinheit nach einem der Ansprüche 1 bis 10,
**dadurch gekennzeichnet,**
**dass** die Federkontaktstifte (3) einen Steckabschnitt (14) aufweisen, der am zum Grundraster weisenden Ende des jeweiligen Federkontaktstiftes (3) ausgebildet ist und einen kleineren Durchmesser als der sich vom Steckabschnitt (14) in Richtung zum Adapter erstreckende Abschnitt des Federkontaktstiftes (3), so dass eine Verjüngungsstelle vorliegt und in der Vollrasterkassette (2) Durchgangsbohrungen (7) zum Aufnehmen jeweils eines Steckabschnittes (14) ausgebildet sind, wobei die Durchgangsbohrungen (7) eine Ringstufe (8) aufweisen die als Anschlag für die Verjüngungsstelle der Federkontaktstifte (3) dient.

## Claims

1. Contacting unit for a test apparatus for testing printed circuit boards, comprising a full grid cassette (2) and an adapter (21), wherein the full grid cassette (2) has a plurality of spring contact pins (3) located in the grid of contact points of a basic grid of the test apparatus and wherein the adapter (21) has test needles (31, 32) provided for electrically connecting each one of the spring contact pins (3) of the full grid cassette (2) to one of the circuit board test points of the printed circuit board to be tested, wherein the test needles (31, 32) in the adapter (21) are secured only against falling out on the side remote from the full grid cassette but not against falling out on the side facing the full grid cassette, and the adapter (21) and the full grid cassette (2) being releasably connected to each other such that the adapter (21) and the full grid cassette (2) form a rigidly joined contacting unit, **characterised in that** the spring contact pins in the full grid cassette are secured only against falling out on the side remote from the adapter (21) but not against falling out on the side facing the adapter.

2. Contacting unit according to claim 1,
**characterised in that**
the releasable connection between the adapter (21) and the full grid cassette (2) is provided by a latching and/or locking device.

3. Contacting unit according to claim 1 or 2,
**characterised in that**
the releasable connection between the adapter (21) and the full grid cassette (2) is provided by a swivel joint (20) and a locking device (49, 50), wherein the swivel joint (20) is located at the edge of the facing surfaces of the adapter (21) and the full grid cassette (2), so that the contacting unit comprising the adapter and the full grid cassette (2) can be folded open and the full grid cassette and the adapter (21) can be locked by means of the locking device (49, 50) in the folded state.

4. Contacting unit according to claim 3,
**characterised in that**
the Swivel joint is releasable.

5. Contacting unit according to any of claims 1 to 4,
**characterised in that**
the spring contact pins (3) are made from a wire with a helically wound spring section and located without sheathing in the full grid cassette (2).

6. Contacting unit according to claim 5,
**characterised in that**
the each of the spring contact pins (3) is helically wound from a wire and the maximum diameter of each spring contact pin (3) does not exceed 0.8 mm, and **in that**, at the end of the spring contact pins which faces the basic grid, the end winding of the wire is wound to a smaller radius than adjacent windings, so that the wire has an end located centrally with respect to adjacent windings and forming a central contact point (15).

7. Contacting unit according to claim 5 or 6,
**characterised in that**
each of the spring contact pins (3) has a trumpet section (12) at the end facing the adapter, which comprises a few windings without axial spacing, and which has a taper which widens again towards the end, so that a depression facing the adapter is created.

8. Contacting unit according to any of claims 1 to 7,
**characterised in that**
the test needles (31) of the adapter (21) are substantially straight without any helical windings and have a thickened section (38) provided to secure the test needles against falling out on the side of the adapter which faces the printed circuit board to be tested.

9. Contacting unit according to any of claims 1 to 8,
**characterised in that**
the full grid cassette is made up from an adapter plate (5) facing the adapter (21) and a basic grid plate (4) facing the basic grid, and **in that** a guide device (9) between the adapter plate (5) and the basic grid plate (4) is designed such that the adapter plate (5) and the basic grid plate (4) are movable relative to each other in the axial direction of the spring contact pins (3) and have a play in the plane extending at right angles to the axial direction (10) of the spring contact pins (3).

10. Contacting unit according to any of claims 1 to 9,
**characterised in that**
the test needles of the adapter (21) include contact needles (31) and/or contact pins (32).

11. Contacting unit according to any of claims 1 to 10,
**characterised in that**
the spring contact pins (3) have a plug-in section (14) formed at the end of the spring contact pins (3) which faces the basic grid and having a smaller diameter than the section of the spring contact pins (3) which extends from the plug-in section (14) towards the adapter, so that there is a tapering point, through holes (7) being provided in the full grid cassette (2) for the accommodation of individual plug-in sections (14), the through holes (7) having an annular step (8) serving as a stop for the tapering point of the spring contact pins (3).

## Revendications

1. Unité de mise en contact pour un dispositif de test destiné à tester des cartes à circuits imprimés, comprenant une cassette à trame complète (2) et un adaptateur (21), dans laquelle la cassette à trame complète (2) comprend une pluralité de pointes de contacts à ressort (3), qui sont agencées suivants la trame des points de contacts d'une trame de base du dispositif de test, et l'adaptateur (21) comprend des aiguilles de contrôle (31, 32) qui sont prévues pour une connexion électrique de l'une des pointes de contacts à ressort (3) de la cassette à trame complète (2) respectivement avec un point de test d'une carte à circuits imprimés à tester, dans laquelle les aiguilles de contrôle (31, 32) sont bloquées dans l'adaptateur (21) uniquement à l'encontre d'une chute sur le côté détourné de la cassette à trame complète, mais non pas à l'encontre de la chute sur le côté tourné vers la cassette à trame complète, et l'adaptateur (21) et la cassette à trame complète (2) sont reliés l'un à l'autre de façon détachable de telle manière que l'adaptateur (21) et la cassette à trame complète (2) sont reliés l'un à l'autre fermement pour former une unité de mise en contact, **caractérisée en ce que** les pointes de contacts à ressort dans la cassette à trame complète sont bloquées uniquement à l'encontre de la chute sur le côté détourné de l'adaptateur (21) mais non pas à l'encontre de la chute sur le côté tourné vers l'adaptateur.

2. Unité de mise en contact selon la revendication 1,
**caractérisée en ce que** la liaison détachable entre l'adaptateur (21) et la cassette à trame complète (2) est un système à enclenchement et/ou un système à verrouillage.

3. Unité de mise en contact selon la revendication 1 ou 2,
**caractérisée en ce que** la liaison détachable entre l'adaptateur (21) et la cassette à trame complète (2) est réalisée par une articulation pivotante (20) et un système de verrouillage (49, 50), dans laquelle l'articulation pivotante (20) est agencée à la bordure des surfaces tournées l'une vers l'autre de l'adaptateur (21) et de la cassette à trame complète (2), de sorte que l'unité de mise en contact, constituée de l'adaptateur et de la cassette à trame complète (2) peut être pivotée à l'ouverture et, dans la situation pivotée rassemblée, la cassette à trame complète et l'adaptateur (21) sont susceptibles d'être verrouillés au moyen du système de verrouillage (49, 50).

4. Unité de mise en contact selon la revendication 3,
**caractérisée en ce que** l'articulation pivotante est réalisée détachable.

5. Unité de mise en contact selon l'une des revendications 1 à 4,
**caractérisée en ce que** les pointes de contacts à ressort (3) sont réalisées respectivement à partir d'un fil avec un tronçon de ressort enroulé en hélice, et sont agencées dans la cassette à trame complète (2) sans enrobage.

6. Unité de mise en contact selon la revendication 5,
**caractérisée en ce que** les pointes de contacts à ressort (3) sont enroulées en forme d'hélice respectivement à partir d'un fil, et le diamètre maximum de chacune des pointes de contacts à ressort (3) n'est pas supérieur à 0,8 mm et, au niveau de son extrémité, tournée vers la trame de base, des pointes de contacts à ressort, la spire terminale du fil est enroulée respectivement avec un rayon plus petit que les spires voisines, de sorte que le fil présente une extrémité qui est agencée au milieu par rapport aux spires voisines et forme un point de contact centré (15).

7. Unité de mise en contact selon la revendication 5 ou 6,
**caractérisée en ce que** les pointes de contacts à ressort (3) présentent chacune, à leurs extrémités tournées vers l'adaptateur, un tronçon en trompette (12) qui comprend quelques spires qui sont réalisées sans écartement axial, et présente un rétrécissement qui va à nouveau en s'élargissant vers l'extrémité, de sorte qu'il se forme un creux tourné vers l'adaptateur.

8. Unité de mise en contact selon l'une des revendications 1 à 7,
**caractérisée en ce que** les aiguilles de contrôle (31) de l'adaptateur (21) sont réalisées sensiblement en ligne droite sans enroulement de forme hélicoïdale, et comportent un épaississement (38), afin de bloquer les aiguilles de contrôle à l'encontre d'une chute sur le côté de l'adaptateur tourné vers la carte à circuits imprimés à tester.

9. Unité de mise en contact selon l'une des revendications 1 à 8, **caractérisée en ce que**
la cassette à trame complète est réalisée à partir d'une plaque d'adaptateur (5) agencée tournée vers l'adaptateur (21), et d'une plaque de trame de base (4) agencée tournée vers la trame de base, et un système de guidage (9) est réalisé entre la plaque d'adaptateur (5) et la plaque de trame de base (5) de telle façon que la plaque d'adaptateur (5) et la plaque de trame de base (4) sont déplaçables l'une par rapport à l'autre en direction axiale des pointes de contacts à ressort, et présente un jeu de mouvement dans le plan transversalement à la direction axiale (10) des pointes de contacts à ressort (3).

10. Unité de mise en contact selon l'une des revendications 1 à 9,
**caractérisée en ce que** les aiguilles de contrôle de l'adaptateur (21) comprennent des aiguilles de contact (31) et/ou des pointes de contact (32).

11. Unité de mise en contact selon l'une des revendications 1 à 10,
**caractérisée en ce que** les tiges de contacts à ressort (3) comportent un tronçon enfichable, qui est réalisé à l'extrémité, tournée vers la trame de base, de la pointe de contact à ressort respective (3), et possèdent un diamètre plus petit que le tronçon, de la pointe de contact à ressort (3), qui s'étend depuis le tronçon enfichable (14) en direction de l'adaptateur, de sorte qu'il existe un emplacement de rétrécissement, et dans la cassette à trame complète, il est prévu des perçages traversants (7) pour recevoir respectivement un tronçon enfichable (14), et les perçages traversants (7) présentent un gradin annulaire (8), qui sert de butée pour l'emplacement de rétrécissement des pointes de contact à ressort (3).
